# EUROPEAN PATENT APPLICATION

(11) **EP 4 091 885 A1**
(43) Date of publication of application: **23.11.2022**
(21) Application number: 21174469.3
(22) Date of filing: 18.05.2021
(51) Int. Cl.: B60R 16/03, B60R 16/033

(54) **VEHICLE POWER DISTRIBUTION CIRCUIT AND VEHICLE POWER SYSTEM INCORPORATING THE SAME**

(71) Applicant: Aptiv Technologies Limited, St. Michael (BB)
(72) Inventor: HEINRICH, Markus, Dublin, 2 (IE); TOURNABIEN, Guillaume, Dublin, 2 (IE)
(74) Representative: Gaunt, Thomas Derrick

(57) **Abstract**

Vehicle power distribution circuit (1) for connecting between a battery (2) and a power line (8) connected to a generator or DC/DC-Converter (6). The circuit (1) has a charging line (7) connecting between the battery (2) and the power line (8) for charging the battery (2) when a forward voltage is applied by the generator or DC/DC-Converter (6). An ideal diode arrangement (11) is provided in the charging line (7) for conducting the forward current from the generator or DC/DC-Converter (6) to the battery (2) when a forward voltage is applied. The ideal diode arrangement (11) prevents the conducting of a reverse current from the battery (2) to the power line (8) when a reverse voltage is applied.

## Description

### Introduction

The present disclosure relates to a vehicle power distribution circuit and a vehicle power system. The present disclosure is particularly relevant to a short circuit protection device for automotive power architectures, vehicle power distribution boxes, and vehicle electrical architectures incorporating short circuit protection.

### Background

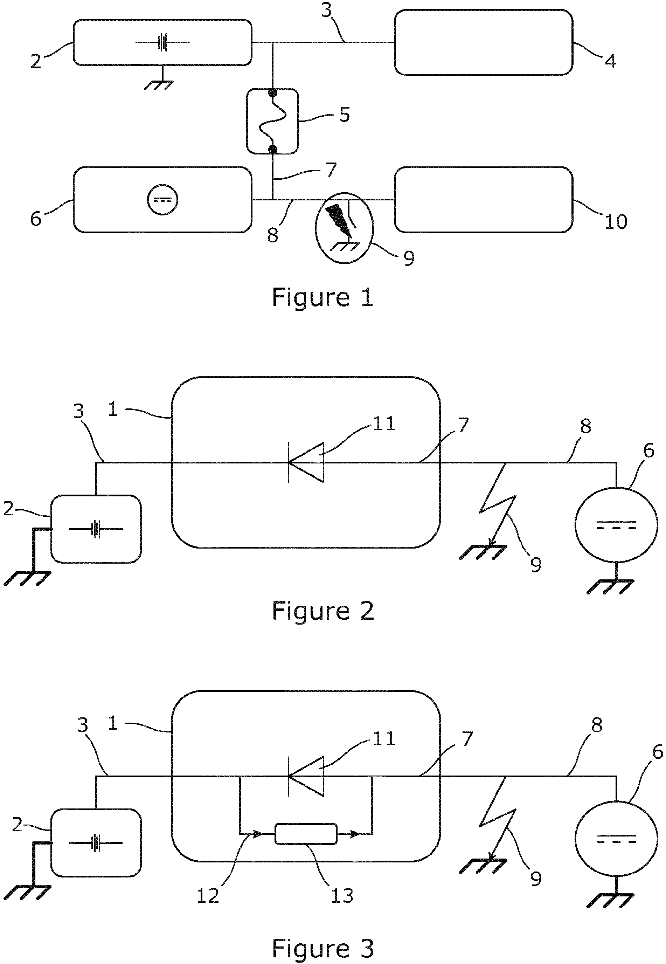

Vehicle power distribution systems are used to distribute electrical power from the vehicle's battery and generator or DC/DC-Converter to various powered modules within the vehicle. Figure 1 shows a schematic illustration of a conventional power distribution system in a vehicle. Within this architecture, the battery 2 provides the main power source for supplying, via a battery power line 3, a number of critical powered modules 4, such as the steering, advanced driver-assistance system (ADAS), and breaking modules. Such modules are considered critical to the safe operation of the vehicle. At the same time, a generator or DC/DC-Converter 6 is provided for supplying a DC current during the running of the vehicle for powering, via a generator or secondary power line 8, a number of noncritical powered modules 10, such as the heating, interior lights, and vehicle entertainment modules. A charging line 7 is further provided between the battery power line 3 and the generator power line 8. When the vehicle is running, the generator or DC/DC-Converter 6 will charge the battery 6 by applying a forward current through the charging line 7.

In conventional architectures, in order to protect the battery 2 and the powered modules 4,10 in the event of a short circuit, a fuse 5 is provided in the charging line 7. As such, if a short circuit causes an excessive current draw through the charging line 7 which exceeds the fuse's threshold, for example 250A, the fuse 5 will melt thereby preventing the current flow.

There are, however, problems with such conventional architectures. Firstly, if a short circuit 9 occurs on the generator line 8, a relatively high reverse current will be drawn from the battery 2, via the battery line 3, through the charging line 7 to the generator line 8. This will thereby cause the voltage on battery line 3 to drop low, which may cause faults in the critical powered modules 4. Furthermore, the fuse 5 will only melt in this scenario if the battery 6 is sufficiently charged to supply a current exceeding the rating of the fuse 5. If, however, the charge in the battery 2 is relatively weak, the fuse 5 may not melt, thereby resulting in the battery line 3 being held low. Conversely, in scenarios where the fuse 5 does melt, it requires replacement before normal vehicle operations can be restored. Given the complexity of modern vehicles this is undesirable.

To address the above shortcomings, arrangements have been proposed which replace the melting fuse 5 with a low voltage switch or a number of field effect transistor (FET) switches under the control of a controller. However, when such arrangements are used to switch off relatively high currents, the large amounts of energy fed through the sensor system and the switch can result in damage to the controller and the switches. This can not only compromise their long-term reliability, but also typically necessitates the provision of heat sinks and thermal management systems to maintain their operation. This increases the cost and size of the assembly as a whole.

Accordingly, there is a need for new vehicle power distribution circuits and systems to address the above shortcomings.

### Summary

According to a first aspect, there is provided a vehicle power distribution circuit for connecting between a battery and a power line connected to a generator or DC/DC-Converter, the circuit including a charging line connecting between the battery and the power line for charging the battery when a forward voltage is applied by the generator or DC/DC-Converter; an ideal diode arrangement provided in the charging line for conducting the forward current from the generator or DC/DC-Converter to the battery when a forward voltage is applied and for preventing the conducting of a reverse current from the battery to the power line when a reverse voltage is applied.

In this way, robust and rapid short circuit protection may be provided, without significant power losses. Importantly, by utilising the characteristics of a perfect or ideal diode arrangement, the current at the moment when the short protection activates is effectively zero. As a consequence, unlike conventional arrangements, energy isn't lost during switching, thereby mitigating potential energy losses as heat. At the same time, the battery line is isolated from short circuits on the power line. Although ideal diode arrangements have previously been used to protect circuits when a battery is accidentally connected in reverse polarity, the present disclosure applies their characteristics to provide short circuit protection for reverse currents to the power line in a vehicle power distribution circuit.

In embodiments, the ideal diode arrangement includes: a MOSFET connected in the charging line; and a controller for driving the MOSFET for emulating an ideal diode. In this way, a low forward voltage drop is achieved across the metal-oxide-semiconductor field-effect transistor (MOSFET), whilst a negligible reverse current is conducted in a short circuit scenario.

In embodiments, the MOSFET includes a body, and a gate, and wherein the gate is driven by the ideal diode controller and the body prevents the reverse current when the MOSFET is turned off by the gate.

In embodiments, the controller includes a comparator for comparing the voltage across the MOSFET, wherein the controller drives the gate to turn off the MOSFET when the comparator detects a reverse voltage across the MOSFET. In this way, a reverse voltage can be detected rapidly, using a robust comparator arrangement.

In embodiments, the vehicle power distribution circuit further includes a bypass circuit for bypassing the ideal diode arrangement, wherein the bypass circuit includes a current regulator for regulating a reverse current through the bypass circuit from the battery to the power line. In this way, a regulated reverse current may be provided from the battery.

In embodiments, the bypass circuit further includes a switch for selectably establishing a bypass current path from the battery to the power line. In this way, the regulated reverse current may be selectively provided when needed.

According to a second aspect, there is provided a vehicle power distribution unit including a vehicle power distribution circuit according to any of the above statements.

According to a third aspect, there is provided a vehicle power system, including: a battery; a generator or DC/DC-Converter; a power line for connecting the generator or DC/DC-Converter to one or more powered modules; and a distribution circuit, the distribution circuit including a charging line connected between the battery and the power line for charging the battery when a forward voltage is applied by the generator or DC/DC-Converter, an ideal diode arrangement provided in the charging line for conducting the forward current from the generator or DC/DC-Converter to the battery when a forward voltage is applied and for preventing the conducting of a reverse current from the battery to the power line when a reverse voltage is applied.

In embodiments, the vehicle power system further includes a battery line for connecting the battery to one or more critical powered modules.

In embodiments, the ideal diode arrangement includes a MOSFET connected in the charging line, and a controller for driving the MOSFET for emulating an ideal diode.

In embodiments, the MOSFET includes a body, and a gate, and wherein the gate is driven by the ideal diode controller and the body prevents the reverse current when the MOSFET is turned off by the gate.

In embodiments, the controller includes a comparator for comparing the voltage across the MOSFET, wherein the controller drives the gate to turn off the MOSFET when the comparator detects a reverse voltage across the MOSFET.

In embodiments, the vehicle power system further includes a bypass circuit for bypassing the ideal diode arrangement, wherein the bypass circuit includes a current regulator for regulating a reverse current through the bypass circuit from the battery to the power line.

In embodiments, the bypass circuit further includes a switch for selectably establishing a bypass current path from the battery to the power line.

### Brief Description of Drawings

Illustrative embodiments will now be described with reference to the accompanying drawings in which:
Figure 1 shows a schematic illustration of a conventional power distribution architecture in a vehicle;
Figure 2 shows a schematic illustration of a power distribution circuit according to a first embodiment; and
Figure 3 shows a schematic illustration of a power distribution circuit according to a second embodiment.

### Detailed Description

Figure 2 shows a vehicle power distribution circuit 1 according to a first embodiment. The power distribution circuit 1 connects between the vehicle's battery 2 and the generator 6 via a power line 8. Within the vehicles overall power system, the power line 8 may be connected to one or more powered modules (not shown in Figure 2), similar to the arrangement shown in Figure 1. Equally, the battery 2 is connected to the vehicle power distribution circuit 1 via battery power line 3, which itself may also be connected to one or more powered modules (not shown in Figure 2) .

A charging line 7 within the power distribution circuit 1 connects between the battery 2 and the generator or DC/DC-Converter 6 via their respective battery and power lines 3,8. An ideal diode arrangement 11 is provided in the charging line 7 and is arranged for conducting a forward current from the generator or DC/DC-Converter 6 to the battery 2 arrangement for charging the battery 2. Conversely, the ideal diode arrangement 11 prevents the conducting of a reverse current from the battery 2 to the power line 8 when a reverse voltage is applied.

As is known in the art, a perfect or ideal diode is not a diode in the conventional sense, but is an arrangement of a MOSFET and an ideal diode controller which emulates the behaviour of an ideal diode. Consequently, the arrangement provides very low forward voltage drop and negligible reverse current when a reverse voltage is applied. Within the arrangement, the source and gate of the MOSFET are connected in the charging line 7 such that the MOSFET body blocks the reverse current when the MOSFET is turned off. Conversely, when the MOSFET is on, the forward voltage drop and power dissipation is minimal. The switching of the MOSFET is controlled by the driving of the MOSFET's gate by the ideal diode controller, which senses a reverse current through the MOSFET, and drives the gate to turn it off, thereby blocking the reverse current.

In this embodiment, the MOSFET is an N-channel MOSFET, although other MOSFET configurations are possible. The ideal diode controller has an internal charge pump for driving the MOSFET gate higher than its anode, a forward comparator for turning on the MOSFET, and a reverse current comparator for turning off the MOSFET when a reverse current is detected. The reverse comparator monitors the voltage across controller's anode and cathode and, if a reverse current is detected, the MOSFET's gate is shorted with a strong pulldown current. This rapidly provides a strong gate drive to pull down the gate to the source voltage, thereby turning off the MOSFET rapidly. As such, the ideal diode arrangement 11 may provide a rapid response to prevent the conduction of a reverse current through the MOSFET and hence the charging line 7. Furthermore, advantageously, by using a comparator, the shutdown current threshold may be set extremely low, thereby allowing the emulation of an ideal diode response.

In use, the vehicle power distribution circuit 1 provides a forward current path for allowing the generator or DC/DC-Converter 6 to charge the battery 2 (shown right to left in Figure 2). As this forward current is conducted through the MOSFET, the forward voltage drop is minimal. Accordingly, this avoids the need for a heat sink that might otherwise be required to manage the waste heat arising from forward conduction power losses, thereby providing both cost and space savings.

The components of the generator or DC/DC-Converter 6 are internally protected from short circuits. However, in the event of a short circuit 9 on the power line 8 or within the generator or DC/DC-Converter 6 itself, the voltage in the power line 8 will drop lower than the battery 2, thereby applying a reverse voltage across the ideal diode arrangement 11. However, the onset of the current reversal causes the ideal diode arrangement 11 to rapidly turn off the MOSFET thereby preventing a reverse current (shown left to right in Figure 2) being conducted through the charging line 7. This thereby prevents the battery line 3 from being drawn low, and hence protects the battery 2 and the associated powered modules 4 from the short circuit 9. Once the short circuit 9 is removed, the forward current through the power distribution circuit is re-established.

Figure 3 shows a vehicle power distribution circuit 1 according to a second embodiment. This embodiment is substantially the same as the first embodiment, except that a bypass circuit 12 is provided for bypassing the ideal diode arrangement 11. The bypass circuit 12 includes a current regulator 13 for regulating a reverse current through the bypass circuit 12. The current regulator 13 includes a switch which when closed establishes the bypass reverse current path from the battery 2 to the power line 8. With this arrangement, a regulated reverse current may be provided from the battery if needed. For instance, the bypass current path may be established for allowing noncritical powered modules to draw power from the battery in situations where the generator or DC/DC-Converter 6 is not actively generating DC power. Nevertheless, in normal operations, the bypass circuit can be disconnected, allowing the ideal diode arrangement 11 to provide short circuit protection in the same way as described in relation to Figure 2.

Accordingly, with the above described arrangements a vehicle power distribution circuit and power architecture system may be provided which allows for robust and rapid short circuit protection, without significant power losses. Importantly, by utilising the characteristics of a perfect or ideal diode arrangement, the current at the moment when the short protection activates, is zero or substantially so. As a consequence, energy isn't lost during switching of the MOSFET, which could otherwise cause heating of the circuit.

It will be understood that the embodiments illustrated above shows an application only for the purposes of illustration. In practice, embodiments may be applied to many different configurations, the detailed embodiments being straightforward for those skilled in the art to implement.

For example, although the arrangement allows for short circuit protection without the need for complex microprocessors, it will be understood that implementations may be used in conjunction with one or more microprocessors, for instance to provide performance feedback and fault monitoring.

Moreover, although a vehicle power distribution circuit has been described in the illustrative embodiments, it will be understood that the circuit may be incorporated into a distribution box or form part of a power distribution system incorporated into a vehicle.

## Claims

1. A vehicle power distribution circuit for connecting between a battery and a power line connected to a generator or DC/DC-Converter, the circuit comprising:
a charging line connecting between the battery and the power line for charging the battery when a forward voltage is applied by the generator or DC/DC-Converter;
an ideal diode arrangement provided in the charging line for conducting the forward current from the generator or DC/DC-Converter to the battery when a forward voltage is applied and for preventing the conducting of a reverse current from the battery to the power line when a reverse voltage is applied.

2. A vehicle power distribution circuit according to claim 1, wherein the ideal diode arrangement comprises:
a MOSFET connected in the charging line; and
a controller for driving the MOSFET for emulating an ideal diode.

3. A vehicle power distribution circuit according to claim 2, wherein the MOSFET comprises a body, and a gate, and wherein the gate is driven by the ideal diode controller and the body prevents the reverse current when the MOSFET is turned off by the gate.

4. A vehicle power distribution circuit according to claim 2 or 3, wherein the controller comprises a comparator for comparing the voltage across the MOSFET, wherein the controller drives the gate to turn off the MOSFET when the comparator detects a reverse voltage across the MOSFET.

5. A vehicle power distribution circuit according to any preceding claim, further comprising a bypass circuit for bypassing the ideal diode arrangement, wherein the bypass circuit comprises a current regulator for regulating a reverse current through the bypass circuit from the battery to the power line.

6. A vehicle power distribution circuit according to claim 4, wherein the bypass circuit further comprises a switch for selectably establishing a bypass current path from the battery to the power line.

7. A vehicle power distribution unit comprising a vehicle power distribution circuit according to any of claims 1 to 6.

8. A vehicle power system, comprising:
a battery;
a generator or DC/DC-Converter;
a power line for connecting the generator or DC/DC-Converter to one or more powered modules; and
a distribution circuit, the distribution circuit comprising:
a charging line connected between the battery and the power line for charging the battery when a forward voltage is applied by the generator or DC/DC-Converter, and
an ideal diode arrangement provided in the charging line for conducting the forward current from the generator or DC/DC-Converter to the battery when a forward voltage is applied and for preventing the conducting of a reverse current from the battery to the power line when a reverse voltage is applied.

9. A vehicle power system according to claim 8, further comprising:
a battery line for connecting the battery to one or more critical powered modules.

10. A vehicle power system according to claim 8 or 9, wherein the ideal diode arrangement comprises:
a MOSFET connected in the charging line; and
a controller for driving the MOSFET for emulating an ideal diode.

11. A vehicle power system according to claim 10, wherein the MOSFET comprises a body, and a gate, and wherein the gate is driven by the ideal diode controller and the body prevents the reverse current when the MOSFET is turned off by the gate.

12. A vehicle power system according to claim 10 or 11, wherein the controller comprises a comparator for comparing the voltage across the MOSFET, wherein the controller drives the gate to turn off the MOSFET when the comparator detects a reverse voltage across the MOSFET.

13. A vehicle power system according to any of claims 8 to 12, further comprising a bypass circuit for bypassing the ideal diode arrangement, wherein the bypass circuit comprises a current regulator for regulating a reverse current through the bypass circuit from the battery to the power line.

14. A vehicle power system according to claim 13, wherein the bypass circuit further comprises a switch for selectably establishing a bypass current path from the battery to the power line.
